# EUROPEAN PATENT APPLICATION

(11) **EP 4 354 517 A1**
(43) Date of publication of application: **17.04.2024**
(21) Application number: 22810923.7
(22) Date of filing: 10.03.2022
(51) Int. Cl.: H01L 31/0264, H01L 31/08

(54) **PLATINUM GROUP METAL CHALCOGENIDE THIN FILM AND SEMICONDUCTOR MATERIAL PROVIDED WITH PLATINUM GROUP METAL CHALCOGENIDE THIN FILM**

(30) Priority: 24.05.2021 JP 2021086779
(71) Applicant: Tanaka Kikinzoku Kogyo K.K., Tokyo 100-6422 (JP); University-Industry Foundation, Yonsei University, Seoul 03722 (KR)
(72) Inventor: NAKAZAWA, Tatsuya, Isehara-shi, Kanagawa 259-1146 (JP); KIM, Hyung Jun, Seoul 03722 (KR); KIM, Dong Hyun, Seoul 03722 (KR)
(74) Representative: Hoffmann Eitle
(86) International application number: PCT/JP2022/010450
(87) International publication number: WO 2022/249642

(57) **Abstract**

The present invention relates to a thin film containing a chalcogenide of Ir or Ru of a platinum group metal. This thin film is formed on a prescribed substrate, contains a platinum group metal chalcogenide, and the platinum group metal chalcogenide contains any one of Ir₂S₃, IrS₂, RuS₂, and RuSe₂. A thickness of the thin film is 0.5 nm or more and 500 nm or less. The present invention has revealed, through an experimental method and simulation using first-principles calculation based on density functional theory (DFT), that a thin film containing Ir₂S₃, IrS₂, RuS₂ or RuSe₂ can exhibit a photoelectric effect by near infrared light irradiation. The present invention is drawn to a thin film that is characterized by sensitivity to light with a wavelength in a near infrared region in particular, and contains a platinum group metal chalcogenide having a constitution previously unknown.

## Description

### BACKGROUND OF THE INVENTION

### FIELD OF THE INVENTION

The present invention relates to a thin film containing a platinum group metal chalcogenide effective as a semiconductor material, particularly a semiconductor material constituting a light receiving element. More particularly, it relates to a platinum group metal chalcogenide thin film in which Ir or Ru is applied as a platinum group metal.

### DESCRIPTION OF THE RELATED ART

A LIDAR (Light Detection and Ranging) has been recently attracting attention as a sensing technique for a remote sensing system used in automatic driving of cars, drones, ships and the like, and face recognition technology and augmented reality (AR) technology in smartphones, tablets and the like. The LIDAR refers to a system for irradiating a target with laser light and sensing reflected light with a light receiving element to detect a distance/angle to/against the target. The LIDAR has an advantage over a detection system using a camera or millimeter-wave radar in that the distance/angle to/against a target can be highly accurately detected.

As a semiconductor material conventionally examined as a light receiving element constituting an optical device such as a LIDAR, a HgCdTe alloy (Hg₁₋ₓCdₓTe alloy: MCT alloy) and an InGaAs alloy (In₁₋ₓGaₓAs alloy) are known. Regarding application of a HgCdTe alloy or an InGaAs alloy to a light receiving element of a LIDAR, however, some problems have been pointed out. For example, a HgCdTe alloy has a low SN ratio at room temperature, and hence the element needs to be cooled for usual use. Addition of a cooling mechanism to a light receiving element unit is not preferable in a drone, a smartphone, and the like that are required to be compact. Besides, also in equipment of cars assuming operation at room temperature, the addition of a cooling mechanism is not preferable. Also an InGaAs alloy is poor in response at room temperature, and further has problems of a high operating voltage and unstability in structure.

Therefore, as a semiconductor material usable instead of a HgCdTe alloy and the like, a transition metal chalcogenide (hereinafter, sometimes referred to as a TMC) has been attracting attention. A TMC refers to a compound of a transition metal (a metal of group III elements to group XI elements) and a chalcogen element excluding oxygen. A TMC exhibits specific electric properties and optical semiconductor properties based on the type of the central metal M, and has been attracting attention as a constituent material of not only a photoelectric conversion element used in a light receiving device but also various semiconductor devices such as a field effect transistor (FET).

Besides, one advantage of a TMC is a degree of freedom of the production method. For a TMC, various thin film formation processes not limited to a specific method are applicable. In particular, it can be produced by chemical deposition methods such as a chemical vapor deposition method (CVD) and an atomic layer deposition method (ALD), which are known as high-yield thin film formation processes. In addition, the material of a substrate to be used has a wide range of choices, and it can be formed also on a Si wafer, or a glass substrate (SiO₂). In these regards, for producing the above-described HgCdTe alloy and the like with desired compositions, it is always necessary to employ MBE (molecular beam epitaxy). Besides, the material of a substrate to be used is limited to expensive CdZnTe, GaAs, and the like. Owing to such a degree of freedom of the production method and the substrate, a TMC can be a low-cost and high-performance semiconductor material.

Examples of specifically known transition metal chalcogenides include sulfides and selenides of transition metals such as Mo, W, Hf, and Zr. In particular, regarding MoS₂, that is, a TMC of Mo, a large number of research examples of devices using it have been reported.

A TMC on which the present applicant is focusing is a chalcogenide having a platinum group metal (such as Pt, or Pd) applied as the transition metal. There have not been many research examples on a TMC of a platinum group metal, but it has been reported that such a TMC has more favorable properties as compared with the above-described TMCs of Mo, W and the like. For example, for application to a light receiving element using, as a target, a near infrared region, to be used in the above-described LIDAR or the like, optimization of a bandgap of a semiconductor material constituting the light receiving element is significant. Regarding the optimization of a bandgap, based on the photon energy equation (E = hc/λ (h: Planck constant, c: light speed, λ: wavelength)), in order to obtain response in a near infrared region, assuming that the region has a wavelength range of 700 nm to 1200 nm, the bandgap of a semiconductor material is required to be lower than about 1.77 eV. According to examination prior to the present invention made by the present inventors, it has been confirmed that a TMC of Pt (platinum), specifically PtSe₂ exhibits a bandgap of 1.20 eV (single layer) to 0.21 eV (double layer), and PtS₂ exhibits a bandgap of 2.66 eV (single layer) to 0.25 eV (double layer). These TMCs are layered compounds, and the properties can be adjusted in accordance with the number of layers, while the above-described bandgap enables to provide a bandgap lower by about 1 eV as compared with a TMC of Mo or the like.

### Prior Art Document

### Patent Document

Patent Document 1: Japanese Patent Publication No. 6-9240
Patent Document 2: Japanese Patent Application Laid-Open No. 2007-165359
Patent Document 3: Japanese Translation of PCT International Application Publication No. 2018-525516

### SUMMARY OF THE INVENTION

### Technical Problem

Even if a TMC of a platinum group metal can exhibit favorable properties as a semiconductor material, only a small number of research results have been obtained in the field of TMCs of platinum group metals, and hence all of them cannot always form favorable materials. Besides, even if a TMC of a platinum group metal has optical response characteristics and photoelectric conversion properties in a near infrared region or the like, it is not suitable for practical use when it is lack of stability as a compound. In addition, as described above, the advantage of a TMC is also a high degree of freedom of the production method. If a TMC can be produced only by a limited production method, the superiority is lowered.

The present invention was made under such a background, and an object is to provide, regarding a transition metal chalcogenide thin film of a platinum group metal, a platinum group metal chalcogenide thin film that has optical semiconductor properties, particularly sensitivity to light with a wavelength in a near infrared region, and has a constitution previously unknown.

### Solution to Problem

In general, examples of metals designated as platinum group metals include Ag (silver), Au (gold), Pt (platinum), Pd (palladium), Ru (ruthenium), Ir (iridium), Rh (rhodium), and Os (osmium). In this regard, there are some examination examples on TMCs of Ag, Au, Pt, and Pd, and the usefulness thereof has been confirmed. For example, sulfides or selenides (dichalcogenide: TMDC) of Pt and Pd, that is, PtS₂, PtSe₂, PdS₂, PdSe₂ and the like, are known to have a layered structure. A TMC having a layered structure can be controlled in properties thereof such as a bandgap by adjusting the number of layers.

On the other hand, there is currently little knowledge of chalcogenides of Ru, Ir, Rh and Os. If a compound having a favorable bandgap can be found among chalcogenides of these platinum group metals, it can be a useful semiconductor material. Therefore, the present inventors have made earnest studies on chalcogenides of Ru, Ir, Rh, and Os based on methods of both experimental verification and theoretical verification, and as a result, Ir and Ru have been selected from the group of the platinum group metals, and thin films of sulfides thereof, Ir₂S₃, IrS₂, RuS₂, and RuSe₂, have been found to be useful. These TMC thin films can exhibit optical semiconductor properties, and in addition, are stable and can be comparatively easily produced.

Specifically, the present invention is drawn to a thin film formed on a substrate and containing a platinum group metal chalcogenide, in which the platinum group metal chalcogenide contains any one of Ir₂S₃ or IrS₂, RuS₂, and RuSe₂, and a thickness of the thin film is 0.5 nm or more and 500 nm or less.

As described above, in the present invention, Ir and Ru are selected as a platinum group metal, and a TMC thin film containing a sulfide thereof is provided. Now, a constitution and a production method of a platinum group metal chalcogenide thin film of the present invention will be described.

### (A) Constitution of Platinum Group Metal Chalcogenide Thin Film of the present Invention

### (A-1) Composition of Platinum Group Metal Chalcogenide Thin Film

As described above, the present invention is drawn to a thin film of a platinum group metal chalcogenide in which Ir or Ru is applied as the platinum group metal. Here, examples of a chalcogen element constituting a chalcogenide of Ir include S (sulfur), Se (selenium), and Te (tellurium). In the present invention, the chalcogenide of Ir is limited to sulfides because these probably have an appropriate bandgap. For example, bandgaps of selenides of Ir (IrSe₂ and Ir₃Se₈) are probably too low. Besides, examples of sulfides of Ir include Ir₂S₃ (diiridium trisulfide), IrS₂ (diiridium disulfide), and Ir₃S₈ (triiridium octasulfide). From the viewpoint of a bandgap, the present invention is limited to thin films containing Ir₂S₃ (diiridium trisulfide) and IrS₂ (diiridium disulfide).

For the same reason as that described above, the present invention is limited to, as a chalcogenide of Ru, RuS₂ (ruthenium disulfide) that is a sulfide of Ru, and RuSe₂ (ruthenium diselenide) that is a selenide of Ru. It is noted that an appropriate bandgap of the present invention is a bandgap advantageous for a photoelectric effect in a near infrared region. In the present invention, the wavelength region of the near infrared region is assumed as 700 nm or more and 2500 nm or less, and the appropriate bandgap is 0.49 eV or more and 1.77 eV.

In addition to the viewpoint of optimization of the bandgap as described above, another reason of selecting Ir₂S₃, IrS₂, RuS₂, and RuSe₂ as the platinum group metal chalcogenides is that these sulfides are expected to have thermal and chemical stability, and are probably favorable as a constituent material of a semiconductor device.

Besides, the chalcogenides (sulfides) of Ir and Ru have three-dimensional crystal structures without employing a layered structure differently from chalcogenides of Pt and Pd. In a TMC not having a layered structure, the properties such as a bandgap are peculiar to the substance, and the bandgap is little changed in accordance with the number of layers (thickness). This leads to an advantage that the thickness can be optionally adjusted in accordance with design of a device to which it is applied.

The platinum group metal chalcogenide contained in the thin film of the present invention has preferably a high purity, and the purity is preferably 99% or more, and more preferably 99.9% or more. The purity here is obtained based on a total mass of Ir and S or a total mass of Ru and S with the mass of the entire thin film used as a reference. In the present invention, incidental impurities may be contained. Examples of incidental impurities contained in the thin film include platinum group metals elements excluding Ir and Ru, and group IV elements (such as Ca, Ti, V, Cr, Mn, Fe, Co, Ni, Cu, Zn, and Ga). A content of these incidental impurities is preferably 100 ppm or less in total.

### (A-2) Structure of Platinum Group Metal Chalcogenide Thin Film

The platinum group metal chalcogenide thin film of the present invention has a thickness of 0.5 nm or more and 500 nm or less. When the thickness is less than 0.5 nm, the crystal structure of the platinum group metal chalcogenide is difficult to be formed, and desired properties may not be obtained. Alternatively, although a TMC thin film having a thickness over 500 nm can be produced, the amount of materials to be used is so large that cost performance is poor, and hence the thickness should be limited. The thickness of the TMC thin film is preferably 0.5 nm or more and 200 nm or less.

Besides, the thin film may be formed on the entire surface of a substrate, or may be formed in an insular shape partially on the substrate. This is because even when the TMC crystal is not formed as a wholly continuous film, semiconductor properties can be exhibited through interaction of TMC crystals present in an insular shape. An insular-shaped thin film refers to a thin film formed based on the Volmer-Weber growth mode. This is a state where three-dimensional islands of the platinum group metal chalcogenide are formed on a substrate. In other words, the state is a transient state before the platinum group metal chalcogenide thin film is formed wholly on the substrate. Including such a case where the insular-shaped thin film is formed, a coverage of the platinum group chalcogenide thin film on the substrate is preferably 10% or more. The coverage is calculated based on a ratio of a surface area of the platinum group metal chalcogenide thin film to a surface area of a substrate surface on which the thin film is formed.

It is noted that the platinum group chalcogenide thin film (including one in an insular shape) of the present invention may have any one of Ir₂S₃, IrS₂, RuS₂, and RuSe₂ present at least on the surface thereof. In other words, metal Ir or metal Ru, or a compound not chalcogenized (sulfurized or selenized) to Ir₂S₃, IrS₂, RuS₂, or RuSe₂ may be present inside the thin film. Although described in detail below, as a production method of a TMC thin film of the present invention, a metal film reaction method for chalcogenizing a metal film (Ir film or Ru film) can be applied. In this production method, since chalcogenization of the metal film proceeds from the surface, a desired platinum group metal chalcogenide is formed on the surface of the thin film, but the inside of the thin film may not be sufficiently chalcogenized. Besides, as a production method of a TMC thin film, a multi-target sputtering method can be also applied, and a metal portion may be present inside the thin film owing to a difference in sputtering efficiency. In the present invention, the thin film may be in such a state. Ir₂S₃, IrS₂, RuS₂, or RuSe₂ is present on a surface contacting with an external electrode when the TMC thin film of the present invention is used as a light receiving element or the like. It goes without saying that the entire thin film including the inside thereof may be constituted by Ir₂S₃, IrS₂, RuS₂, or RuSe₂.

### (A-3) Substrate

The thin film of the platinum group metal chalcogenide of the present invention is formed on an appropriate substrate. The substrate is a member for supporting the thin film. The material of the substrate may be any material as long as it can support the platinum group metal chalcogenide thin film. Examples of the material include glass, quartz, silicon, ceramics, and metals. Besides, the shape and the size of the substrate are not especially limited.

### (B) Semiconductor Material Including Platinum Group Metal Chalcogenide Thin Film of the present Invention

The platinum group metal chalcogenide thin film of the present invention is useful as a semiconductor material for photoelectric conversion or light absorption/emission. This semiconductor material can be used as a photoelectric conversion element for use in an optical device such as a light receiving device, an optical sensor, or a light detector. The semiconductor material of the present invention has favorable sensitivity to light with a wavelength in a near infrared region in particular. Therefore, it is specifically suitable to a light receiving element for use in a LIDAR or a SWIR image sensor.

### (C) Production Method of Platinum Group Metal Chalcogenide Thin Film of the present Invention

Next, a production method of the platinum group metal chalcogenide thin film of the present invention will be described. The platinum group metal chalcogenide thin film of the present invention is produced by forming a platinum group metal chalcogenide film on the above-described substrate. A film formation method employed at this point is not especially limited, and a conventional production method of a transition metal chalcogenide is applied. As the production method of a platinum group metal chalcogenide of the present invention, a metal film reaction method in which a thin film of a platinum group metal (Ir or Ru) is formed on a substrate, and the resultant thin film is heat treated in a chalcogenization atmosphere (sulfur atmosphere or selenium atmosphere) to chalcogenize (sulfurize or selenize) the platinum group metal film can be employed.

As a film formation method of a platinum group metal thin film (Ir thin film, or Ru thin film), known thin film formation processes including physical vapor deposition methods such as a sputtering method, and a vacuum deposition method, and chemical deposition methods such as a chemical vapor deposition method (CVD method), and an atomic layer deposition method (ALD method) can be applied. In particular, when a sputtering method or a chemical deposition method is employed, a platinum group metal thin film having a desired thickness can be efficiently obtained.

In the film formation of the platinum group metal thin film by a sputtering method, an Ir target or a Ru target is preferably used. As sputtering conditions, usual conditions can be employed. As an Ir target or a Ru target, a high purity product having a content of the corresponding metal of 99% or more is preferably applied.

As basic steps of the film formation process employing a chemical deposition method (CVD method or ALD method), the film formation is conducted by vaporizing a metal compound used as a raw material

(precursor) of the thin film, supplying a raw material gas thus generated onto a substrate, and causing a chemical reaction (decomposition reaction or synthesis reaction) in the gas phase to deposit a target substance on the substrate. As examples of the precursor of the platinum group metal used in the chemical deposition method, for Ir, organic iridium compounds such as tricarbonyl[(1,2,3-η)-1,2,3-tris(1,1-dimethylethyl) -2-cyclopropen-1-yl]iridium (TICP), tris(acetylacetonato)iridium (Ir(acac)₃), and (cyclohexadienyl)methylcyclopentadienyliridium ((MeCp)lr(CHD)) can be used. For Ru, organoruthenium compounds such as tricarbonyl(trimethylenemethane)ruthenium ([Ru(TMM)(CO)₃) dicarbonylbis(5-methyl-2,4-hexanedionato)ruthenium, hexacarbonyl[methyl-(1-methylpropyl)-butene-aminato]diruthenium, and dodecacarbonyltriruthenium (DCR) can be used.

Besides, in the chemical deposition method, a rection gas is generally supplied onto a substrate surface for promoting decomposition of the metal compound in the raw material gas. As the reaction gas, oxygen, hydrogen or the like is applied in accordance with the type of the precursor (metal compound), which is not especially limited in the present invention. In addition, as film formation conditions to be employed in the CVD method or the ALD method, conditions employed in a usual chemical deposition method are applied.

In the formation of the thin film of the platinum group metal (Ir or Ru), the film is formed into a thickness corresponding to a thickness of the platinum group metal chalcogenide to be produced. Then, the thus formed platinum group metal thin film is treated in a chalcogenization atmosphere, and thus, the platinum group metal chalcogenide thin film is formed. For forming the chalcogenization atmosphere, a hydrogen sulfide (H₂S) gas or hydrogenated selenium (H₂Se) can be used. Alternatively, solid sulfur or selenium can be used, and is vaporized by a sublimation method by heating to form a chalcogenization atmosphere. For the chalcogenization of the platinum group metal thin film, the thin film is preferably heated in a chalcogenization atmosphere. A heating temperature is, for chalcogenization of Ir, preferably 800°C or more and 1100°C or less, and for chalcogenization of Ru, preferably 600°C or more and 1300°C or less. When the temperature is lower than the lower limit of these temperature ranges, the chalcogenization is insufficient, and when the temperature exceeds the upper limit, the chalcogenide is concerned to be decomposed. For the chalcogenization of Ir, when the treatment is performed at a high temperature within the above-described temperature range, Ir₂S₃ can be priorly generated. A heating time is preferably 30 minutes or more and 12 hours or less.

In addition to the metal film reaction method described so far, the platinum group metal chalcogenide thin film can be produced also by directly forming the platinum group metal chalcogenide on a substrate. For example, in employing a sputtering method, the platinum group metal chalcogenide thin film can be produced by reactive sputtering using a platinum group metal target. Alternatively, the platinum group metal chalcogenide thin film can be produced by using, as a sputtering target, a platinum group metal chalcogenide produced by powder metallurgy or the like. When the chemical deposition method is employed, the platinum group metal chalcogenide thin film can be synthesized directly on a substrate by using a chalcogenization source (such as a H₂S gas or Se vapor) as a reaction gas. Alternatively, the platinum group metal chalcogenide thin film can be produced also by transferring or applying, onto a substrate, a platinum group metal chalcogenide having been synthesized in another container or on another substrate.

### Advantageous Effects of Invention

As described above, the present invention relates to a platinum group metal chalcogenide thin film in which Ir or Ru is applied as a platinum group metal. The platinum group metal chalcogenide thin film of the present invention has an appropriate bandgap as a semiconductor material constituting a light receiving element and the like. In particular, it has sensitivity to light with a wavelength in a near infrared region, and hence can be expected to be replied to a device including a light receiving element for the region. Besides, the platinum group metal chalcogenide thin film of the present invention has a high degree of freedom of the production method, and hence can be produced by various thin film production methods, and has good stability.

### BRIEF DESCRIPTION OF THE DRAWINGS

Fig. 1 is a diagram illustrating results of XPS analysis of an Ir₂S₃ thin film and a RuS₂ thin film produced in First Embodiment;
Fig. 2 is a diagram illustrating evaluation results of optical response characteristics (740 nm, 850 nm, and 940 nm) of the Ir₂S₃ thin film and the RuS₂ thin film produced in First Embodiment;
Fig. 3 is a diagram illustrating results of XPS analysis of an Ir₂S₃ thin film and a RuS₂ thin film produced in Second Embodiment;
Fig. 4 is a diagram illustrating evaluation results of optical response characteristics (740 nm, 850 nm, and 940 nm) of the Ir₂S₃ thin film and the RuS₂ thin film produced in Second Embodiment;
Fig. 5 is a diagram illustrating results of XRD analysis of the RuS₂ thin films produced in First Embodiment and Second Embodiment;
Fig. 6 is a diagram illustrating a density of electronic states in Ir₂S₃ and RuS₂ obtained by DFT calculation; and
Fig. 7 is a diagram illustrating optical response characteristics of a RuSe₂ thin film produced in Fourth Embodiment.

### DETAILED DESCRIPTION OF THE PREFERRED EMBODIMENTS

First Embodiment: Now, an embodiment of the present invention will be described. In the present embodiment, an Ir thin film and a Ru thin film were formed by a sputtering method, and the resultant films were chalcogenized to produce platinum group metal chalcogenide thin films. Then, these platinum group metal chalcogenide thin films were evaluated for optical response characteristics to near infrared light.

### [Production of Platinum Group Metal Chalcogenide Thin Film]

In the formation of the Ir thin film and the Ru thin film, the films were formed by using an Ir target and a Ru target having a purity of 99.99% as targets, and using a magnetron sputtering apparatus as a sputtering apparatus. As a substrate, a Si/SiO₂ substrate (oxidized in a surface portion of 280 nm, dimension: 20 × 20, thickness: 1.5 mm) was used. As film formation conditions, pre-sputtering was conducted at 50 W for 10 seconds for cleaning, and then sputtering was conducted at 50 W. A chamber pressure applied in the film formation was 0.7 Pa. Thus, Ir thin films and Ru thin films respectively having a thickness of 1.0 nm and 2.0 nm were formed.

For chalcogenization of the thin films, the substrates having the films formed thereon were placed in a tube furnace, H₂S was introduced into the furnace, and heating was performed under an air stream of 10 sccm. A heating temperature was 900°C for the Ir films, and 800°C for the Ru films, and the heat treatment was conducted for 1 hour for both.

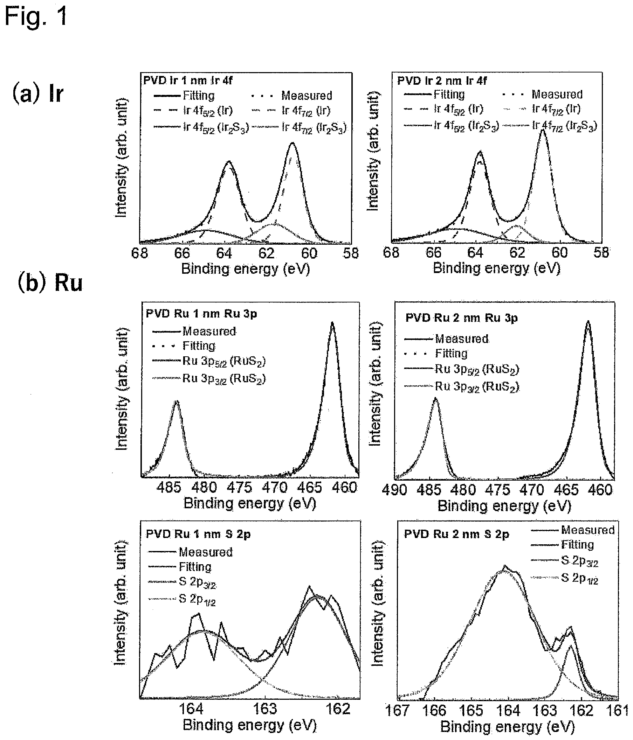

The thus produced platinum group metal chalcogenide thin films were analyzed by X-ray photoelectron spectroscopy (XPS). Results of the XPS analysis are illustrated in Fig. 1. As for the RuS₂ thin films, since a difference in the peak position (binding energy) between a spectrum of metal Ru and a Ru3p spectrum of RuS₂ is as small as about 0.2 eV, a measurement result of a S2p spectrum is also illustrated. It was confirmed, based on the results of the XPS analysis, that a thin film containing Ir₂S₃ and a thin film containing RuS₂ were formed in the present embodiment. In the Ir₂S₃ thin film, metal Ir partially remained, but it is deemed that Ir₂S₃ was present on the surface. Besides, AFM measurement was conducted to measure an actual thickness of each platinum group metal chalcogenide thin film. As a result, the Ir₂S₃ thin films respectively had a thickness of 1. 8 nm (that was 1 nm before the heat treatment) and 2.5 nm (that was 2 nm before the heat treatment). The RuS₂ thin films respectively had a thickness of 1.5 nm (that was 1 nm before the heat treatment) and 2.3 nm (that was 2 nm before the heat treatment).

### [Evaluation of Optical Response]

The platinum group metal chalcogenide thin films (Ir₂S₃ thin films and RuS₂ thin films) produced as described above were evaluated for optical response characteristics as semiconductor properties. In the present embodiment, an interdigitated array electrode was formed on the surface of each of the produced thin films to produce a light receiving element of a photoelectric conversion element. The interdigitated array electrode was formed by patterning a Ti film (thickness: 5 nm) and a Au film (thickness: 40 nm) successively into an interdigitated array on the surface of the platinum group metal chalcogenide thin film.

The thus produced light receiving elements were measured for optical response to near infrared light. As a measurement method, each light receiving element was irradiated with near infrared light, and a photocurrent was measured at room temperature with a multimeter. The wavelength of the irradiating near infrared light was set to 3 patterns of 740 nm, 850 nm, and 940 nm, and response characteristics at the respective wavelengths were measured. As the irradiation with the near infrared light, irradiation for 20 seconds was intermittently performed at an interval of 30 seconds. A bias voltage of 3.0 V was applied by the multimeter.

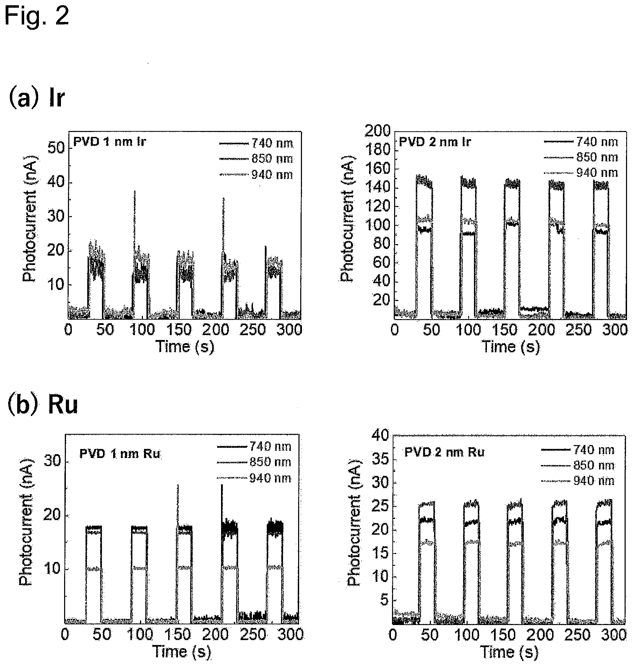

Evaluation results of the optical response characteristics of the platinum group chalcogenide thin films of the present embodiment are illustrated in Fig. 2. It was confirmed, based on these measurement results, that the platinum group metal chalcogenide thin films (the Ir₂S₃ thin films (1.0 nm, and 2.0 nm) and the RuS₂ thin films (1.0 nm, and 2.0 nm)) produced in the present embodiment exhibit optical response in the near infrared region of 740 nm to 940 nm.

Second Embodiment: In the present embodiment, a Ru thin film and an Ir thin film were formed by a chemical deposition method, and the resultant metal thin films were chalcogenized to produce platinum group metal chalcogenide thin films. Then, optical response characteristics thereof were evaluated in the same manner as in First Embodiment.

### [Production of Platinum Group Metal Chalcogenide Thin Film]

A substrate (Si/SiO₂ substrate) the same as that used in First Embodiment was prepared, and a Ru thin film and an Ir thin film were formed on this substrate by an ALD method. The ALD method is a thin film formation process for repeating a cycle of an adsorption step of introducing a raw material gas into a reactor to adsorb a raw material onto a substrate surface, a purge step of exhausting an excessive portion of the raw material gas, a reaction step of introducing a reaction gas into the reactor for causing a reaction between the raw material adsorbed onto the substrate surface and the reaction gas to deposit a metal, and a purge step of exhausting an excessive portion of the reaction gas. First, the substrate was set in an ALD apparatus, and a reactor was purged with a nitrogen gas (100 sccm) before the film formation.

For forming a Ru thin film, a Ru complex of tricarbonyl(trimethylenemethane)ruthenium ([Ru(TMM)(CO)₃) was used as a precursor. Film formation conditions as follows were employed to form a Ru thin film. The number of repeating the cycle of the steps (1) to (4) was adjusted to control the thickness of the film. In the present embodiment, three samples were produced by ALD of 42 cycles (thickness: 4 nm) and 50 cycles (thickness: 6 nm).
(1) Adsorption Step
   - Raw material heating temperature: 10°C
   - Carrier gas: nitrogen/50 sccm
   - Introduction time: 10 sec
(2) Raw Material Gas Purge Step
   - Purged with nitrogen gas (100 sccm)
   - Introduction time: 10 sec
(3) Reaction Step
   - Reaction gas: pure oxygen/ 50 sccm
   - Introduction time: 10 sec
(4) Reaction Gas Purge Step
   - Purged with nitrogen gas (100 sccm)
   - Introduction time: 10 see

Besides, for producing an Ir thin film, an Ir complex of tricarbonyl[(1,2,3-η)-1,2,3-tris(1,1-dimethylethyl)-2-cyclopropen-1-yl]iridium was used as a precursor. Film formation conditions as follows were employed to form an Ir₂S₃ thin film. The number of repeating the cycle was 384 cycles (thickness: 4 nm) and 412 cycles (thickness: 4 nm).

(1) Adsorption Step
   - Raw material heating temperature: 55°C
   - Carrier gas: nitrogen/100 sccm
   - Introduction time: 7 sec
(2) Raw Material Gas Purge Step
   - Purged with nitrogen gas (100 sccm)
   - Introduction time: 10 sec
(3) Reaction Step
   - Reaction gas: pure oxygen/ 50 sccm
   - Introduction time: 2 sec
(4) Reaction Gas Purge Step
   - Purged with nitrogen gas (100 sccm)
   - Introduction time: 10 sec

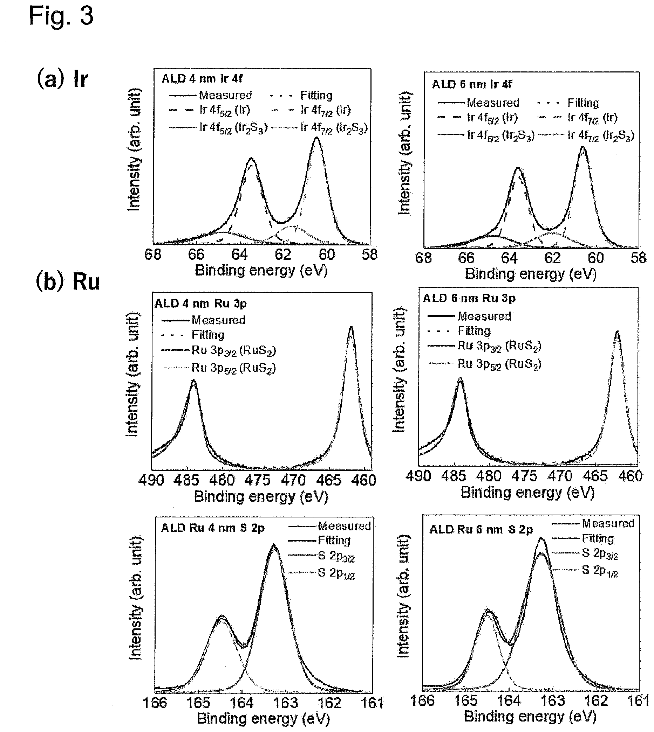

Then, the thus formed Ru thin film and Ir thin film were chalcogenized under the same conditions as those employed in First Embodiment to produce platinum group metal chalcogenide thin films. Results of XPS analysis are illustrated in Fig. 3. It was thus confirmed that Ir₂S₃ and RuS₂ were generated in the present embodiment. Besides, when AFM measurement was conducted to measure the thickness of each platinum group metal chalcogenide thin film, it was found that the Ir₂S₃ thin films had a thickness of 4.9 nm (that was 4 nm before the heat treatment) and 6.5 nm (that was 6 nm before the heat treatment), and the RuS₂ thin films had a thickness of 4.4 nm (that was 4 nm before the heat treatment) and 8.8 nm (that was 6 nm before the heat treatment).

### [Evaluation of Optical Response]

The thus produced platinum group metal chalcogenide thin films (Ir₂S₃ thin films and RuS₂ thin films) were used to produce light receiving elements in the same manner as in First Embodiment. Then, these light receiving elements were evaluated for optical response characteristics in a near infrared region. The measurement method was the same as that employed in First Embodiment, and the wavelength of the irradiating near infrared light was set to 3 patterns of 740 nm, 850 nm, and 940 nm, and response characteristics at the respective wavelengths were measured.

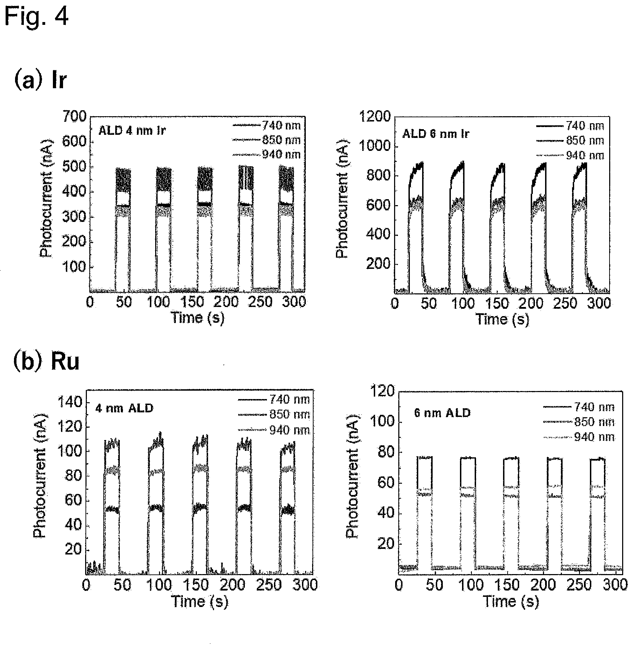

Evaluation results of the optical response characteristics of the Ir₂S₃ thin films and the RuS₂ thin films of the present embodiment are illustrated in Fig. 4. It was thus confirmed that the platinum group metal chalcogenide thin films of the present embodiment also can exhibit optical response in the near infrared region of 740 nm to 940 nm. It is noted that the platinum group metal chalcogenide thin films of First Embodiment and the present embodiment are all produced by the metal film reaction method of sulfurizing a metal thin film. It is deemed that differences in the metal film production method (the sputtering method, or the ALD method) does not affect whether or not optical response is obtained.

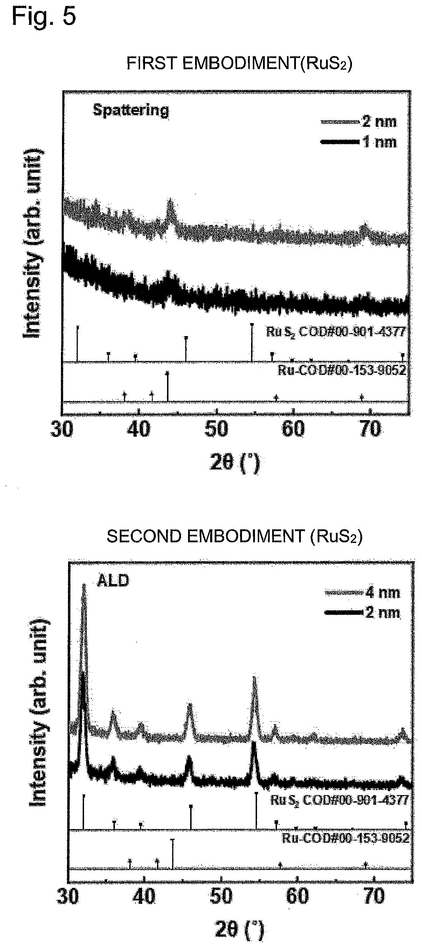

In the comparison between First Embodiment (by the sputtering method) and the present embodiment (by the ALD method), however, although the thickness is different, the platinum group metal chalcogenide thin films of the present embodiment have a higher photocurrent value. This difference is probably because of crystallinity of the platinum group metal chalcogenide. In order to clear this point, results of XRD analysis of the RuS₂ thin films produced in First Embodiment and the present embodiment are illustrated in Fig. 5. It is understood, from Fig. 5, that the thin films produced in the present embodiment contains RuS₂ having high crystallinity. On the other hand, in the thin films produced in First Embodiment, a peak of RuS₂ is difficult to discriminate, and a peak of metal Ru is also observed. Although the generation of RuS₂ was confirmed in the results of the XPS analysis of First Embodiment (Fig. 2), metal Ru inside the thin film, which cannot be detected by XPS, was probably confirmed by the XRD. Based on this, it is presumed that RuS₂ (Ir₂S₃) may be formed at least on the surface for imparting optical semiconductor properties to a thin film, but for generating a stronger photocurrent, the thin film is preferably sulfurized to the inside thereof.

Third Embodiment: The present embodiment describes examination results on properties of a platinum group metal chalcogenide by theoretical verification against the experimental verification of First and Second Embodiments. In this examination, simulation using first-principles calculation based on density functional theory (DFT) was conducted. DFT is a theory that the ground state properties, such as an electron distribution and an energy, of an interacting many-electron system can be calculated using an electron density function. The first-principles calculation based on the DFT is a calculation method based on the density functional theory. According to the first-principles calculation, an electron structure of a substance can be quantitatively examined without using an experimental/experiential parameter.

In the present embodiment, an electronic state was simulated by using VASP, that is, first-principles calculation application (DFT code) based on the density functional theory. In the simulation, atomic structure data of general purpose database of Materials Project (reference: A. Jain et al., "The Materials Project: A materials genome approach to accelerating materials innovation", APL Materials, 2013, 1(1), 011002) was used. In the present embodiment, bandgaps (in the bulk state) of chalcogenides (sulfides and selenides) of the respective platinum group metals of Ir, Ru, and Rh were calculated.

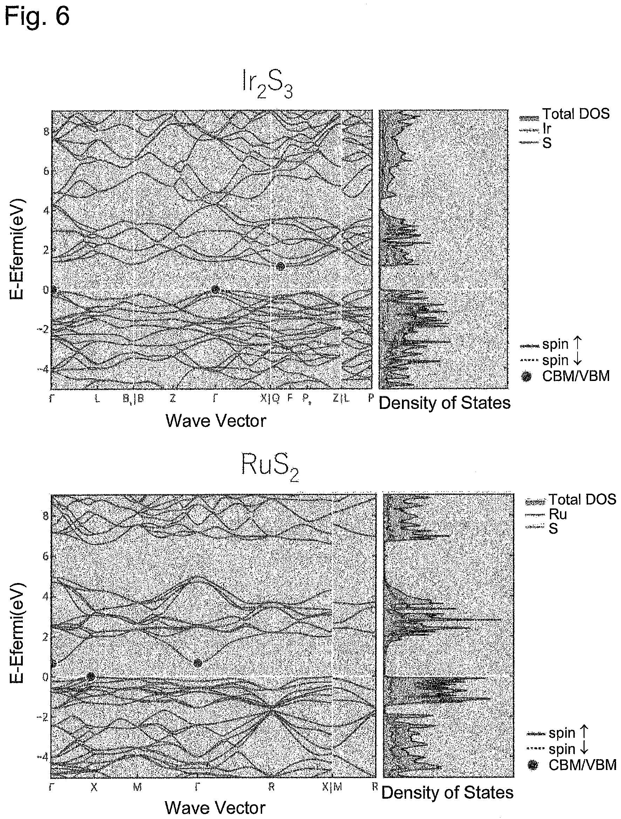

According to DFT calculation, DOS information (information on density of electronic state) of various platinum group metal chalcogenides can be obtained. As examples thereof, Fig. 6 illustrates DOS calculation results of Ir₂S₃ and RuS₂. Then, based on the thus obtained DOS information, the bandgaps of the various platinum group metal chalcogenides were calculated. In these calculation results, bandgaps and absorption wavelengths of various chalcogenides of Ir, Ru, and Rh are shown in Tables 1 to 3.

**[Table 1]**

| **Formula** | **Bandgap (eV)** | **Wavelength (nm)** |
|---|---|---|
| Ir₂S₃ | 1.145 | 1083 |
| Ir₃S₈ | 0 | 0 |
| IrS₂ | 0.564 | 2198 |
| Ir₃Se₈ | 0 | 0 |
| IrSe₂ | 0.067 | 1.852×10⁴ |

**[Table 2]**

| **Formula** | **Bandgap (eV)** | **Wavelength (nm)** |
|---|---|---|
| RuS₂ | 0.682 | 1818 |
| RuSe₂ | 0.479 | 2589 |

**[Table 3]**

| **Formula** | **Bandgap (eV)** | **Wavelength (nm)** |
|---|---|---|
| Rh₁₇S₁₅ | 0 | 0 |
| RhS₂ | 0 | 0 |
| Rh₂S₃ | 0.192 | 6456 |
| Rh₃S₄ | 0 | 0 |
| Rh₂Se₃ | 0 | 0 |
| Rh₃Se₈ | 0 | 0 |
| RhSe₂ | 0 | 0 |

It was first confirmed, based on the DFT calculation results of Tables 1 to 3, that Rh has a low bandgap, and hence is difficult to exhibit properties as a semiconductor material, which corresponds to the problem to be solved by the present invention.

Besides, it is understood that Ir and Ru showed different results from Rh, and can exhibit favorable bandgaps. It is deemed that a selenide of Ru (RuSe₂) is liable to have a low bandgap, and a sulfide thereof (RuS₂) is favorable. The values of these bandgaps are, however, calculation results obtained through semi-DFT, and it is necessary to take it into consideration that the values are evaluated to be smaller than actual bandgaps. In other words, it is presumed that practical applicability of RuSe₂ in a near infrared region of 1200 nm or more should not be excluded. This point is confirmed in Fourth Embodiment.

Also sulfides of Ir exhibit a favorable value, and particularly Ir₂S₃ and IrS₂ can exhibit favorable bandgaps. These results of the theoretical verification by the DFT calculation agree with that the Ir₂S₃ thin film and RuS₂ thin film exhibited favorable optical response characteristics in First and Second Embodiments.

Here, in order to confirm the DFT calculation results, a chalcogenide thin film having Rh applied as a platinum group metal (Rh₂S₃) was produced. In the production of the Rh chalcogenide thin film, a Rh thin film was first formed by sputtering. The Rh thin film was formed from a Rh target having a purity of 99.99% using the same sputtering apparatus (magnetron sputtering apparatus) under the same film formation conditions as those employed in First Embodiment (thickness: 2 nm). Sulfurization of the Rh thin film was performed by heating under H₂S stream (10 sccm) at 900°C for 1 hour also in the same manner as in First Embodiment.

Next, in order to confirm whether or not the thus produced Rh₂S₃ thin film has electrical conductivity, an I-V curve was measured by a four-terminal method, and thus, it was observed that a voltage was liable to increase as a current increased. Specifically, the Rh₂S₃ thin film is a conductor. It is estimated, based on Table 3 above, that Rh₂S₃ is a conductor because a value of the bandgap thereof calculated by DFT is as very small as 0.192 eV, which agrees with this measurement result.

Fourth Embodiment: In the present embodiment, a RuSe₂ thin film, which was suggested to have a low bandgap through the DFT calculation described above, was produced to confirm optical response at 1550 nm. In the present embodiment, the Ru thin film was formed by a chemical deposition method, and the metal thin film was selenized to produce a RuSe₂ thin film. Then, in the same manner as in First and Second Embodiments, the optical response characteristics were evaluated.

### [Production of RuSe₂ Thin Film]

The same substrate (Si/SiO₂ substrate) as that used in First and Second Embodiments was prepared, and a Ru thin film was formed on the substrate by an ALD method. The ALD method is a thin film formation process for repeating a cycle of an adsorption step of introducing a raw material gas into a reactor to adsorb a raw material onto a substrate surface, a purge step of exhausting an excessive portion of the raw material gas, a reaction step of introducing a reaction gas into the reactor for causing a reaction between the raw material adsorbed onto the substrate surface and the reaction gas to deposit a metal, and a purge step of exhausting an excessive portion of the reaction gas. First, the substrate was set in an ALD apparatus, and a reactor was purged with a nitrogen gas (100 sccm) before the film formation.

For forming a Ru thin film, a Ru complex of tricarbonyl(trimethylenemethane)ruthenium ([Ru(TMM)(CO)₃) was used as a precursor. Film formation conditions as follows were employed to form a Ru thin film. The number of repeating the cycle of the steps (1) to (4) was adjusted to control the thickness of the film. In the present embodiment, a sample was produced through 42 cycles (thickness: 4 nm).
(1) Adsorption Step
   - Raw material heating temperature: 10°C
   - Carrier gas: nitrogen/50 sccm
   - Introduction time: 10 sec
(2) Raw Material Gas Purge Step
   - Purged with nitrogen gas (100 sccm)
   - Introduction time: 10 sec
(3) Reaction Step
   - Reaction gas: pure oxygen/ 50 sccm
   - Introduction time: 10 sec
(4) Reaction Gas Purge Step
   - Purged with nitrogen gas (100 sccm)
   - Introduction time: 10 sec

For selenization of the thin film, the substrate having the film formed thereon and a selenium powder were placed in a tube furnace, and heating was performed under an argon gas stream of 10 sccm. At this point, the selenium powder was placed on an upstream side of the gas stream in the tube furnace, and thus, selenium vapor was transported by the argon gas. A heating temperature was 800°C for the substrate having the film, and 220°C for the selenium powder, and the heat treatment was conducted for 1 hour. The thickness of the thin film was changed to 12 nm through the selenization.

### [Evaluation of Optical Response]

The thus produced RuSe₂ was used to produce a light receiving element in the same manner as in First and Second Embodiments. The light receiving element was evaluated for optical response characteristics in a near infrared region. The measurement method was the same as that employed in First Embodiment, and the wavelength of the irradiating near infrared light was set to 1550 nm to measure response characteristics.

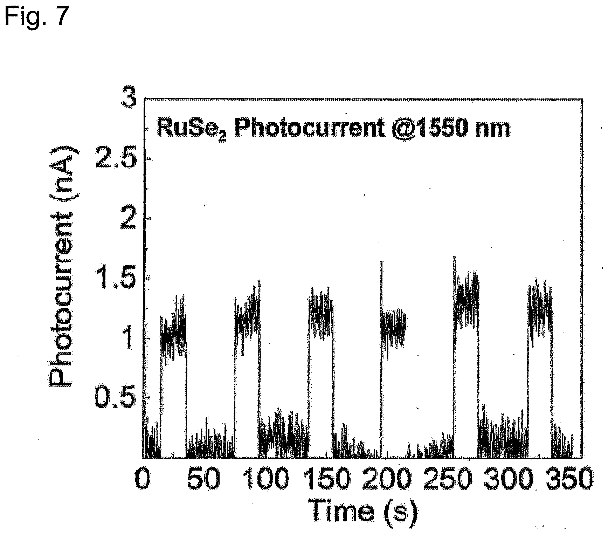

Evaluation results of the optical response characteristics of the RuSe₂ thin film of the present embodiment are illustrated in Fig. 7. It was confirmed that the RuSe₂ thin film of the present embodiment can exhibit optical response in a near infrared region of 1550 nm.

### Industrial Applicability

As described so far, the present invention has revealed that an Ir₂S₃ thin film, an IrS₂ thin film, a RuS₂ thin film, and a RuSe₂ thin film are useful as novel platinum group metal chalcogenide thin films. The platinum group metal chalcogenide thin films of the present invention have an appropriate bandgap as a semiconductor material constituting a light receiving element or the like, and also have sensitivity to light with a wavelength in a near infrared region. The platinum group metal chalcogenide thin films of the present invention can be comparatively easily produced, and have a high degree of freedom of the production. Besides, the platinum group metal chalcogenide thin films have good stability. The present invention is applicable, as a novel semiconductor material, to a light receiving element of an optical device such as a LIDAR, or a SWIR image sensor.

## Claims

1. A thin film formed on a substrate, and comprising a platinum group metal chalcogenide,
wherein the platinum group metal chalcogenide comprises any one of Ir₂S₃, IrS₂, RuS₂, and RuSe₂, and
a thickness of the thin film is 0.5 nm or more and 500 nm or less.

2. The thin film according to claim 1, wherein the thickness of the thin film is 0.5 nm or more and 200 nm or less.

3. The thin film according to claim 1, wherein the thin film is formed in an insular shape on the substrate.

4. A semiconductor material, comprising a substrate, and the thin film defined in any one of claims 1 to 3 formed.

5. A light receiving element, comprising the semiconductor material defined in claim 4.
